# EUROPÄISCHE PATENTSCHRIFT

(11) **EP 0 823 196 B1**
(45) Veröffentlichungstag und Bekanntmachung des Hinweises auf die Patenterteilung: **17.05.2000**
(21) Anmeldenummer: 97919301.8
(22) Anmeldetag: 21.02.1997
(51) Int. Cl.: H05K 7/20, H01L 23/473

(54) **KÜHLKÖRPER ZUM KÜHLEN VON LEISTUNGSBAUELEMENTEN**
COOLING BODY FOR COOLING POWER GATES
ELEMENT DE REFROIDISSEMENT POUR REFROIDIR DES ELEMENTS DE PUISSANCE

(30) Priorität: 24.02.1996 DE 19606972
(43) Veröffentlichungstag der Anmeldung: 11.02.1998
(73) Patentinhaber: DaimlerChrysler AG, 70567 Stuttgart (DE)
(72) Erfinder: BECKER, Klaus, D-55411 Bingen (DE); STAIGER, Wolfgang, D-70188 Stuttgart (DE); JUNG, Matthias, D-14089 Berlin (DE); HEINEMEYER, Peter, D-14052 Berlin (DE)
(86) Internationale Anmeldenummer: EP9700838
(87) Internationale Veröffentlichungsnummer: WO9731512

(56) Entgegenhaltungen:
- WO-A-95/17765
- DE-A- 4 421 025
- DE-C- 3 739 585
- US-A- 5 329 994

## Beschreibung

Die Erfindung betrifft einen Kühlkörper zum Kühlen von Leistungsbauelementen.

Es ist bekannt, Leistungsbauelemente mittels Kühlkörpern in Form sogenannter Kühlschienen zu kühlen. Das Kühlmedium strömt in Längsrichtung durch die Kühlkanäle und führt so die Verlustwärme von auf der Außenseite des Kühlkörpers montierter Leistungsbauelemente ab. Da die Kenndaten der Bauelemente stark temperaturabhängig sind, wird angestrebt, einen Temperaturgradienten in Längsrichtung auf der Kühlfläche von maximal 5 K nicht zu überschreiten.

In der Patentschrift DE-C-39 08 996 ist ein keramischer Kühlkörper mit mehreren Kühlkanälen im Innern des Kühlkörpers offenbart, bei dem benachbarte Kühlkanäle im Innern des Kühlkörpers teilweise parallel und teilweise antiparallel durchströmt werden. Der Nachteil der Anordnungen liegt darin, daß die Wärmeabfuhr unzureichend ist. Längs der Strömungsrichtung bildet sich ein großer Temperaturgradient aus. Die zu kühlenden Bauelemente sind nicht auf gleichem Temperaturniveau.

In der WO-A-95/17765 ist eine Anordnung offenbart, bei der ein Kühlrohr so in einen Kühlkörper gepreßt ist, daß im Kühlrohr Querschnittsverengungen ausgebildet werden. Nachteilig ist hier, daß der Strömungswiderstand stark erhöht wird und die Strömung an den Verengungen nicht zuverlässig abreißt, sondern laminar weiterströmen kann. Weiterhin stellt der Übergang vom Kühlkörper in das eingepreßte Kühlrohr einen unerwünschten Wärmewiderstand dar, der die Kühlung verschlechtert.

Aus der DE-A-44 01 607 ist eine beidseitig offene Kühlschiene bekannt, bei der eine in regelmäßigen Abständen durchbohrte Trennwand parallel zur Strömungsrichtung in das Innere des Kühlkanals geschoben ist. Das Innere der Kühlschiene ist dadurch in zwei Kühlkanäle unterteilt. Zusätzlich sind Verwirbelungs- oder Strömungsabrißkörper in jeden der beiden Kühlkanäle eingeführt, um durch die erzeugten Turbulenzen im Kühlmedium die Kühlung längs des Kanals zu homogenisieren und zu verbessern. Diese Maßnahme führt jedoch zu einer drastischen Erhöhung des Strömungswiderstandes im Kühlkanal, die bei den üblichen hohen Strömungsgeschwindigkeiten in Kühlkörpern für Leistungsbauelemente nicht toleriert werden kann. Weiterhin ist der Wärmewiderstand zwischen der eingeschobenen Trennwand und/oder den eingeschobenen Verwirbelungskörpern und der Kühlschiene nicht vernachlässigbar, so daß die Trennwand und die Einschübe als solche kaum zur Wärmeabfuhr beitragen.

Kühlkörper für Leistungsbauelemente werden häufig mit Kühlmittelgeschwindigkeiten und Druckgefällen im Kühlkanal betrieben, die an der oberen Leistungsgrenze des Kühlkörpers hinsichtlich Durchsatz und Wärmeabfuhr liegen.

Der Erfindung liegt daher die Aufgabe zugrunde, einen Kühlkörper anzugeben, bei dem die Kühlung verbessert ist, ohne den Strömungswiderstand der Anordnung drastisch zu erhöhen.

Die Aufgabe wird durch die Merkmale des Anspruchs 1 gelöst. Weiterführende und vorteilhafte Ausgestaltungen sind den Unteransprüchen und der Beschreibung zu entnehmen.

Die Erfindung geht davon aus, im Innern eines Kühlkörpers längs des Kühlkanals gezielt scharfkantige Strömungsabrißzentren derart anzuordnen, daß die Strömung zuverlässig abreißt. Der Gesamtquerschnitt des Kühlkanals ist senkrecht zur Strömungsrichtung an den Strömungsabrißzentren in zwei Dimensionen erweitert, in der Breite und in der Höhe des Kühlkanals. Der Strömungswiderstand der Anordnung wird dadurch nicht wesentlich erhöht.

Die Erweiterung ist quer zur Strömungsrichtung um den Kühlkanal umlaufend ausgebildet und bietet so den Vorteil einer Vergrößerung der inneren Oberfläche des Kühlkanals. Damit wird der Wärmeübergang vom Kühlkörper in das Kühlmedium verbessert.

Vorteilhaft ist, daß die Erweiterungen in Begrenzungswänden von einzelnen Kühlkanälen und/oder Trennwänden zwischen mehreren Kühlkanälen angeordnet sind. Diese Wände sind mindestens einseitig materialschlüssig mit dem Kühlkörper verbunden und bieten so einen sehr günstigen Wärmeübergang ins Kühlmedium.

In einer bevorzugten Ausführungsform ist der Kühlkörper aus einem Stück gebildet. Günstig ist es, den Kühlkörper durch Strangpressen, insbesondere mit Aluminium oder Aluminium-Legierungen herzustellen, was preiswert und einfach durchzuführen ist.

In einer weiteren bevorzugten Ausführungsform ist der Kühlkörper aus mehreren. insbesondere zwei Stücken, insbesondere Deckel und Boden gebildet. Besonders zweckmäßig ist es, die Kühlkanäle und die Erweiterungen in einem ersten Teil auszubilden, insbesondere durch Fräsen, und die Anordnung mit einem Deckel dicht zu verschließen.

In einer weiteren bevorzugten Ausführungsform sind im wesentlichen senkrecht zu den Dimensionen der Erweiterung weitere, insbesondere scharfkantige Strömungsabrißzentren im Kühlkanal quer zur Strömungsrichtung angeordnet. Besonders vorteilhaft ist diese Anordnung in mehrteiligen Kühlkörpern mit Deckel und Boden, in welchen Kanalwände und Erweiterungen und/oder weitere, insbesondere im Bereich der Erweiterungen angeordnete, Strömungsabrißzentren ausgebildet sind und die zusammengefügt den Kühlkörper bilden. Der Wärmedurchgang von der zu kühlenden Außenseite des Kühlkörpers in das Kühlmedium wird im Mittel über die gesamte Länge der Kühlkanäle erhöht. Durch die erfindungsgemäße Anordnung ist die Ausbildung eines Temperaturgradienten wird deutlich vermindert und die Zuverlässigkeit der Anordnung erhöht.

Besonders vorteilhaft ist, daß der Wärmeübergangskoeffizient α, der bei ungestörter Strömung in Strömungsrichtung abnimmt, hinter einem Strömungsabrißzenturm jeweils wieder stark ansteigt. Vorteilhaft ist weiterhin, daß das Temperaturniveau der Kühlanordnung insgesamt gesenkt ist.

Die Erfindung ist anhand von Abbildungen näher beschrieben.

Es zeigen:
- Fig. 1: einen Schnitt längs eines Kühlkanals mit kanalverbreiternden Strömungsabrißzentren,
- Fig. 2a: den Verlauf des Wärmeübergangskoeffizienten entlang eines erfindungsgemäßen Kühlkanals,
- Fig. 2b: den Temperaturverlauf entlang eines erfindungsgemäßen Kühlkanals,
- Fig. 3: einen Schnitt durch einen erfindungsgemäßen Kühlkanal mit Strömungsabrißzentren,
- Fig. 4a: einen Schnitt längs eines Kühlkanals mit Strömungsabrißzentren,
- Fig. 4b: einen Schnitt längs eines Kühlkanals mit Strömungsabrißzentren,
- Fig. 5: einen Schnitt längs eines erfindungsgemäßen mehrteiligen Kühlkanals mit Strömungsabrißzentren.

Tritt ein Kühlmedium in einen Kühlkanal eines Kühlkörpers ein, insbesondere mit dem Geschwindigkeitsprofil einer Kolbenströmung, bildet sich zwischen den Begrenzungswänden des durchströmten Kanals und dem Kühlmedium, das sich entlang des Kanals bewegt, eine Grenzschicht aus, innerhalb der das Kühlmedium eine zur Kanalwand hin stark abnehmende Geschwindigkeit aufweist. Diese Grenzschicht bringt einen hohen Wärmewiderstand mit sich.

In Strömungsrichtung wächst die jeweilige Grenzschicht von allen Begrenzungswänden her solange an, bis die Grenzschichten in der Kanalmitte zusammentreffen und eine Rohrströmung ausgebildet ist. Gleichzeitig nimmt jedoch der Wärmeübergangskoeffizient α mit wachsender Grenzschichtdicke d proportional zu 1/d ab. Die Wärmeabfuhr von der Kanalbegrenzungswand zum Kühlmedium ist im Zustand der Rohrströmung deutlich verschlechtert.

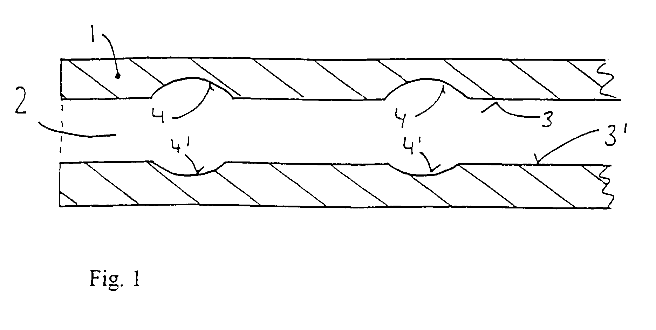

Figur 1 zeigt einen Längsschnitt durch eine erste erfindungsgemäße Ausführungsform eines Kühlkanals mit Strömungsabrißzentren. Die Höhe des Kühlkanals soll senkrecht zur Bildebene sein. Der Querschnitt des Kühlkanals kann rund oder eckig sein. In den folgenden Beispielen sind im wesentlichen eckige, insbesondere rechteckige Querschnitte beschrieben, die Erfindung ist jedoch nicht auf diese Querschnitte eingeschränkt.

In einem erfindungsgemäßen Kühlkörper 1 ist im Innern mindestens ein Kühlkanal 2 ausgebildet. Die Strömungsrichtung liegt in der Bildebene. Der Kühlkanal 2 weist lokale Erweiterungen auf, wobei der Querschnitt des Kühlkanals 2 in bestimmten Abständen durch konkave Einbuchtungen 4, 4' in der Kanalwand 3, 3' quer zur Strömungsrichtung erweitert ist. Bevorzugt sind die Erweiterungen 4, 4' scharfkantig ausgebildet. Die Strömung reißt an den scharfen Kanten der Erweiterungen 4, 4' zuverlässig ab mit der Folge, daß die Ausbildung einer Rohrströmung unterbrochen wird.

Mit dem Abreißen der Strömung verschwindet lokal die Grenzschicht, und der Wärmeübergangskoeffizient α ist unmittelbar hinter dem Ende eines Strömungsabrißzentrums 4, 4' sehr hoch. In Strömungsrichtung nimmt die Grenzschichtdicke d wieder zu, und der Wärmeübergangskoeffizient α fällt dann auf dem weiteren Strömungsweg wieder mit wachsender Grenzschichtdicke d ab.

Die Erweiterungen 4, 4' sind quer zur Strömungsrichtung in der Kanalinnenwand 3, 3' angeordnet und verbreitern den Gesamtquerschnitt des Kühlkanals in zwei Dimensionen. Für rechteckige Kanal-Querschnitte bedeutet dies, daß im Bereich der Erweiterungen sowohl ein Breitenzuwachs als auch ein Höhenzuwachs der Abmessungen des Kühlkanals 2 vorliegt. Der Breitenzuwachs des Kühlkanals 2 entspricht der Tiefe der Erweiterung, der Höhenzuwachs des Kühlkanals entspricht der Höhe der Erweiterung. Für andere Querschnitte, insbesondere runde Querschnitte, gelten die Dimensionen der Erweiterungen sinngemäß. Bevorzugt ist die Erweiterung zum Kanal hin offen.

Die Erweiterungen 4, 4' sind an den sich gegenüberliegenden Kanalinnenwänden 3, 3' angeordnet, können jedoch auch nur an einer Kanalwand oder gleichzeitig an drei oder allen vier Innenwänden angeordnet sein, wobei sie sich vorzugsweise gegenüberliegen. Besonders bevorzugt sind die Erweiterungen, wenn sie den Kühlkanal 2 umlaufend vergrößern. In einer Ausführungsform umschließt die Umfangskurve des Gesamtquerschnittes des Kühlkanales im Bereich der Erweiterung die Umfangskurve des Querschnittes des Kühlkanals außerhalb der Erweiterung. Die beiden Umfangskurven können ein gemeinsames Zentrum oder zwei verschiedene Zentren umschließen.

Die Kühlschiene selbst kann aus einem Stück oder auch mehrstückig gebildet sein, insbesondere aus einer oberen und einer unteren Hälfte. In einer ersten Ausführungsform sind in jede Hälfte mindestens ein Kühlkanal eingefräst und Strömungsabrißzentren in die Trennwänden eingearbeitet. In einer weiteren Ausführungsform ist mindestens ein Kühlkanal mit Strömungsabrißzentren nur in eine Hälfte eingearbeitet, wobei die erste Hälfte mit der zweiten Hälfte dicht verschlossen wird.

Die Erweiterungen 4, 4' selbst sind lokal etwas weniger gut gekühlt als der Kanal 2 selbst. Liegen sich die Erweiterungen 4, 4' paarweise und an allen vier Kanalinnenwänden gegenüber, ist es vorteilhaft, wenn diese sich jeweils auf derselben Länge des Kühlkanals 2 befinden. Die Erweiterungen 4, 4' können jedoch auch alternierend an den Kühlkanalwänden einzeln und/oder auch paarweise gegenüberliegend entlang der Längserstreckung des Kühlkanals angeordnet sein.

Wird als Kühlmedium insbesondere Wasser verwendet, führt die Ausbildung einer Grenzschichtdicke d dazu, daß der Wärmeübergangskoeffizient α von weit über 6000 bei minimaler Grenzschichtdicke auf unter 1500 W/(m²K) im Bereich von z.B. d≈100 µm fällt. Bevorzugt sind die Strömungsabrißzentren daher so in ihren Abmessungen und Abständen zueinander zu optimieren, daß die Grenzschichtdicke d der Strömung an der Kanalbegrenzungswand 3 gering genug bleibt, um einen ausreichend großen Wärmeübergangskoeffizienten α zu gewährleisten.

Erfindungsgemäß werden die Abstände L der Erweiterungen 4, 4' voneinander mindestens so klein gewählt, daß der Wärmeübergangskoeffizient α längs der Strömungsrichtung vorzugsweise auf höchstens ein Viertel des maximalen Wertes fallen kann, welcher für α unmittelbar hinter dem Ende des Strömungsabrißzentrums erreichbar ist. Zweckmäßigerweise muß der Abstand L aber groß genug sein, daß die schlechtere lokale Wärmeabfuhr im Strömungsabrißzentrum 4, 4' selbst die Temperatur des Kühlkörpers nicht wesentlich, vorzugsweise höchstens um 5 K, erhöht.

Die Ausdehnung der Erweiterungen 4, 4' in Strömungsrichtung und/oder die Tiefe der Erweiterungen 4, 4' in der Kanalwand ist so vorzusehen, daß die Strömung beim üblichen Strömungsmitteldurchsatz (bei Wasser, Öl oder dergl. bevorzugt ca. 1 m/s, bei Gas bevorzugt 5-10 m/s) zuverlässig abreißt. Die Dimension der Ausdehnung in Strömungsrichtung soll nicht zu groß sein, da die Kühlung lokal am Strömungsabrißzentrum wegen der auftretenden Turbulenzen verschlechtert ist und auch nicht zu klein, um die Strömung zuverlässig abreißen zu lassen. Die Kühlmittelgeschwindigkeit ist zweckmäßigerweise möglichst groß, aber geringer als die den Kühlkörper abrasiv schädigende Geschwindigkeit.

Vorzugsweise ist die Tiefe der Erweiterungen quer zur Strömungsrichtung mindestens doppelt so groß wie die Grenzschichtdicke d an dieser Stelle mit ungestörter Strömung, insbesondere mindestens gleich der fünffachen Dicke. Die Grenzschichtdicke d hängt von verschiedenen Größen, insbesondere den Abmessungen des Kanals, der Strömungsgeschwindigkeit, den Abständen etwaiger Strömungsabrißzentren und dem Kühlmedium ab und kann z.B. durch Simulationsrechnungen bestimmt werden.

Bei einem Kanalquerschnitt von z.B. 5x5 mm², dem Kühlmedium Wasser, einer Strömungsgeschwindigkeit von ca. 1 m/sec und einem Abstand der Strömungsabrißzentren von 15 cm ist die Tiefe der Erweiterungen vorzugsweise mit 0,5-1 mm zu wählen. Die Höhe der Erweiterungen 4, 4' ist vorzugsweise mindestens gleich oder größer als die lokale Kühlkanalhöhe. Bei runden Kanalquerschnitten ist die Höhe vorzugsweise mindestens gleich dem halben Durchmesser des Kühlkanals. Vorteilhaft ist eine radial umlaufende Querschnittsverbreiterung des runden Kühlkanals.

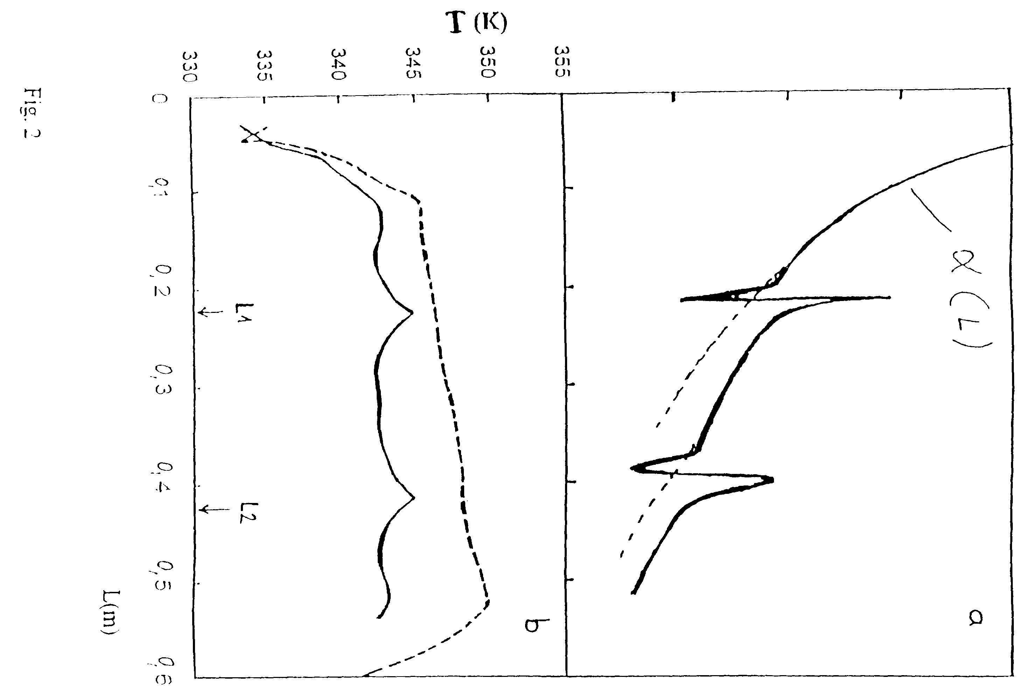

In Fig. 2 sind Simulationsergebnisse für einen Kühlkanal mit einer Länge von 0,6 m angegeben, in dem zwei Strömungsabrißzentren L1 und L2 angeordnet sind. Fig. 2a zeigt den schematischen Verlauf des Wärmeübergangskoeffizienten α entlang des Kühlkanals. Nach jedem Strömungsabrißzentrum ist der Wert deutlich höher als vor dem Strömungsabrißzentrum. Fig. 2b zeigt den Temperaturverlauf entlang des Kühlkanals. Am Strömungsabrißzentrum ist die Temperatur zwar lokal leicht erhöht, außerhalb der Strömungsabrißzentren bleibt jedoch die Temperatur im wesentlichen konstant. Insgesamt ist der Temperaturanstieg entlang des Kanals gering, verglichen mit dem Ergebnis für einen Kühlkanal ohne Strömungsabrißzentren, das durch die gestrichelte Kurve dargestellt ist.

Die zu kühlenden Leistungsbauelemente werden vorteilhafterweise in den Bereichen der Kühlflächen des Kühlkörpers angebracht, bei denen derartige Temperaturplateaus ausgebildet sind.

Die Strömungsabrißzentren in Form von Kanalquerschnittserweiterungen haben den besonderen Vorteil, daß kein zusätzlicher Druckverlust entlang des Kühlkanals 2 auftritt und die Verwirbelung des Kühlmittels im wesentlichen strömungswiderstandsneutral erfolgt oder nur geringfügig den Strömungswiderstand, insbesondere um maximal 20%, bevorzugt nicht mehr als 10% erhöht.

Eine einfache und kostengünstige Art der Herstellung einer einstückigen Kühlschiene, insbesondere einer stranggepreßten Kühlschiene, besteht darin, die Erweiterungen durch Bohrungen senkrecht zum Kühlkanal zu erzeugen. Bevorzugt ist der Durchmesser der Bohrung größer als die Abmessungen des Kühlkanals senkrecht zur Bohrung. Dies hat zur Folge, daß durch die Bohrung an allen Kühlkanalwänden gleichzeitig scharfkantige Strömungsabrißzentren in Form von quer zu Strömungsrichtung den Kanal umlaufenden scharfkantigen Stoßkanten ausgebildet werden. Ein Schnitt längs des Kühlkanals entspricht dem Bild, das in Figur 1 angegeben ist, wobei die Seitenwände parallel zur Bildebene sind. Die Tiefe der Erweiterung entspricht nun der Tiefe der Durchbohrung der Seitenwand der Kühlkanäle und die Höhe der Erweiterung der Tiefe der konkaven Einbuchtung aus Fig. 1. Ist der Durchmesser der Bohrung geringer oder gleich der Kühlkanaldimension quer zur Bohrung, sind nur an den beiden durchbohrten Kühlkanalwänden Strömungsabrißzentren ausgebildet.

Beide Ausführungen zeichnen sich jedoch durch den zusätzlichen Vorteil aus, daß die Erweiterungen jeweils in einer Kanalbegrenzungswand angeordnet sind und daher zumindest einseitig materialschlüssig mit dem Kühlkörper verbunden sind. Die innere Oberfläche des Kühlkanals ist vergrößert und der Wärmeübergang ins Kühlmedium besonders günstig. Die Bohrungen können anschließend in den Begrenzungswänden nach außen mit geeigneten Mitteln dicht verschlossen werden.

Besonders vorteilhaft ist, wenn mehrere derartige Kühlkanäle parallel zueinander in einer Ebene angeordnet sind. Eine obere und untere Begrenzungsfläche des Kühlkörpers parallel zu dieser Ebene können als Kühlflächen dienen, auf die zu kühlende Leistungsbauelemente aufgebracht sind. Insbesondere können die Trennwände der Kanäle in der oben beschriebenen Weise durchbohrt werden.

Mit einer Anordnung wie in DE-A-44 01 607 würde es nicht gelingen, Kühlkanalserweiterungen in zwei Dimensionen anzubringen. Die Kühlkanalserweiterung kann dort zwar als Breitenzuwachs erfolgen, aber die Höhe der Erweiterung kann grundsätzlich nur geringer als die Höhe des Kanals sein. Wäre die Erweiterung von derselben Abmessung wie der Kanal, würde die eingeschobene Trennwand auseinanderfallen. Eine den Kanalquerschnitt quer zur Strömungsrichtung umlaufende Erweiterung des Kühlkanals ist mit der dort gezeigten Anordnung nicht realisierbar.

Strömt das Kühlmedium im Innern des erfindungsgemäßen Kühlkörpers nur in eine Richtung, findet zwischen den einzelnen parallelen Kühlkanälen 2 kein nennenswerter Strömungsaustausch statt, selbst wenn die Bohrungen in den Trennwänden unverschlossen bleiben, da in allen Kanälen 2 in etwa die gleichen Strömungsbedingungen herrschen. Sollen benachbarte Kühlkanäle auch antiparallel durchströmt werden können, werden mit Vorteil die Bohrungen in den Trennwänden zwischen den einzelnen Kühlkanälen mit Stopfen verschlossen, wodurch ein Strömungsaustausch nahezu vollständig unterbunden wird.

Ein einfaches Mittel zum Abdichten der Bohrungen in den Trennwänden ist das Einführen von Stäben, die zumindest bereichsweise zumindest teildurchlässig sind, insbesondere massiv auf der Höhe der Trennwände, jedoch durchlässig auf der Höhe der Kühlkanäle 2 ausgebildet sind. Der Stab verläuft senkrecht zur Strömungsrichtung und bringt den zusätzlichen Vorteil mit sich, im Bereich der Erweiterungen die Strömung in der Kanalmitte zusätzlich zu verwirbeln.

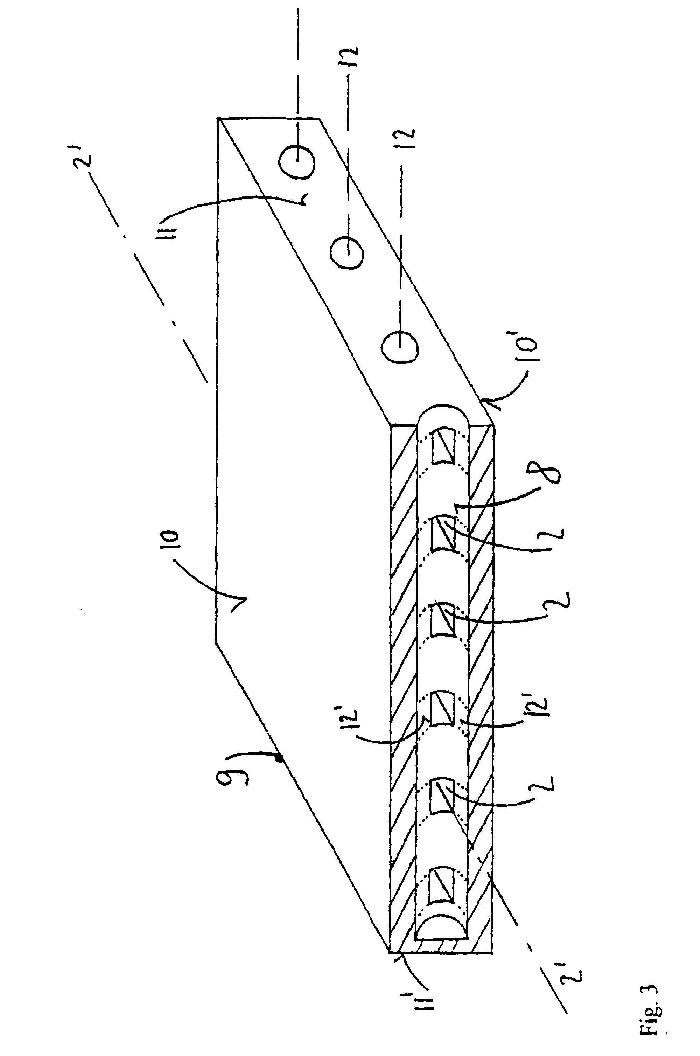

In Fig. 3 ist ein Schnitt quer zur Strömungsrichtung eines erfindungsgemäßen Kühlkörpers 9 dargestellt, der mehrere parallele, in einer Ebene angeordnete Kühlkanäle 2 aufweist. Die Strömungsrichtung ist im wesentlichen schräg zur Bildebene. Bevorzugt wird ein Metall, z.B. Aluminium, für den Kühlkörper verwendet. Besonders bevorzugt ist, die parallelen, in einer Ebene verlaufenden Kühlkanäle durch Stranggepressen von Aluminium herzustellen. Die obere und die untere Kühlfläche 10, 10' der Anordnung, die parallel zu der Ebene der Kühlkanäle verlaufen, kann z.B. 4 übliche IGBT-Leistungsmodule mit jeweils 1 kW Verlustleistung aufnehmen. Die Kühlkanäle 2 sind jeweils ca. 50 cm lang und weisen einen rechteckigen Querschnitt von etwa 5x7 mm² auf. Kühlmittelanschlüsse und etwaige eingangs- und/oder ausgangsseitig angeordnete Kühlmittelreservoire und/oder etwaige Einlaßhilfen sind nicht eingezeichnet.

Der Kühlkörper 9 ist an einer ersten äußeren Schmalseite 11 senkrecht zu den parallelen Kanälen 2 in Abständen von ca. 15 cm durchbohrt, wobei der Mittelachse der Bohrungen 12 jeweils die Kanalmittenachse 2' schneidet und die Bohrungen 12 durch die Zwischenwände 13 durchgeführt sind. Der Durchmesser der Bohrungen ist ungefähr 2 mm größer als die Kanalbreite von 7 mm, so daß jeweils an zwei gegenüberliegenden Kanalwänden an den Innenseiten der Kühlflächen 10, 10' kreisbogenförmige Einbuchtungen 12' mit einer maximalen Tiefe von rund 1 mm senkrecht zur Kanalachse 2' ausgebildet sind. Die Umfangskurve des Gesamtquerschnitts des Kühlkanals im Bereich der Erweiterung umfaßt symmetrisch die Umfangskurve des Querschnitts des Kühlkanls außerhalb der Erweiterung. Die Ausdehnung der Erweiterung in Strömungsrichtung entspricht der Sehne des Kreisbogens der Bohrung in der den Kühlkanal begrenzenden Wandung.

Die der ersten Schmalseite 11 gegenüberliegenden zweite äußere Schmalseite 11' ist nicht völlig durchbohrt oder geeignet verschlossen. Die Bohrungen an der ersten Schmalseite 11 sind ebenfalls verschlossen. Fläche 8 ist die Seitenwand einer Bohrung 12.

Messungen zeigen, daß im Temperaturverlauf auf einer äußeren Kühlkörperoberfläche in Strömungsrichtung, wobei der Kühlkörper von Wasser mit einer Strömungsgeschwindigkeit von etwa 1 m/sec durchströmt wird, lokal nur geringe Schwankungen zu beobachten sind und über die gesamte Länge ein Temperaturgradienten von nur 1 K auftritt. Zusätzlich ist die Temperatur des durchströmenden Kühlmediums am Ausgang der Kühlschiene 9 deutlich niedriger als bei einer Ausführung ohne Strömungsabrißzentren, in Übereinstimmung mit der Simulation in Fig. 2. Der Temperaturgradient längs einer Anordnung ohne Strömungsabrißzentren ist etwa fünfmal so hoch wie bei der erfindungsgemäßen Lösung. Besonders vorteilhaft ist, daß die Zwischenwände 13 zwischen den Kühlkanälen erheblich zur Wärmeabfuhr mit beitragen, da sie materialschlüssig mit den oberen und unteren Kühlkörperoberflächen verbunden sind.

Da Kühlkörper für Leistungsbauelemente üblicherweise unter Bedingungen eingesetzt sind, die an der oberen Grenze ihrer Leistungsfähigkeit liegen, erhöht die erfindungsgemäße Lösung die Sicherheit beim Betrieb derartiger Kühlkörper.

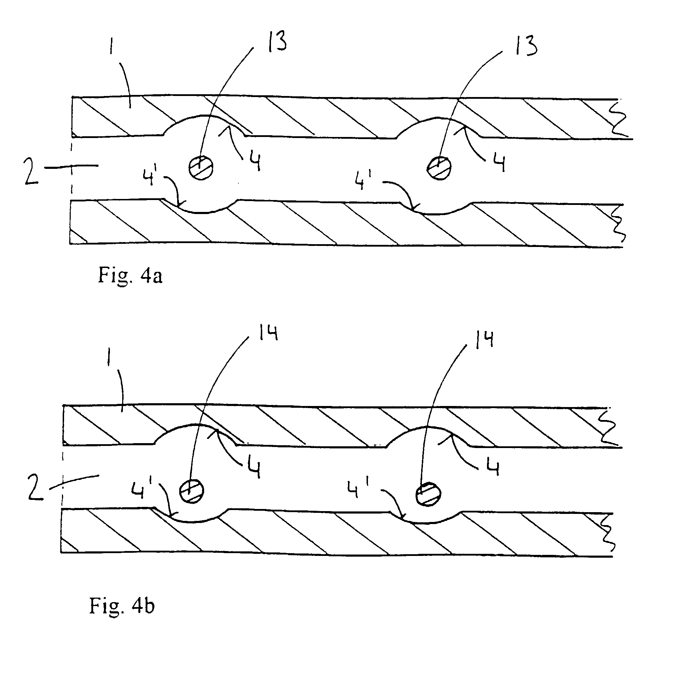

In Fig. 4 sind weitere erfindungsgemäße Anordnungen von Strömungsabrißzentren dargestellt, die gegenüber einem ungestörten Kühlkanal nahezu strömungswiderstandneutral wirken. Die Strömungsrichtung liegt in der Bildebene. Hier sind Körper 13, 14, insbesondere zylinderförmige oder scharfkantig begrenzte Körper, quer zum Strömungsweg in den Kühlkanal 2 eingeführt. Diese Körper können entweder in der Kanalmitte (Fig. 4a, Körper 13) oder nahe der Kanalwand angeordnet sein (Fig. 4b, Körper 14). Im wesentlichen strömungswiderstandsneutral im vorher genannten Sinne ist die Anordnung dann, wenn die Körper 13, 14 im Bereich der Erweiterungen angeordnet sind und die Querschnitte der Körper 13, 14 kleiner oder in etwa gleich dem Flächenzuwachs des Kühlkanalquerschnitts durch die Erweiterung sind.

Eine einfache Art der Ausführung besteht darin, diese Körper in Form von Stäben in die Bohrungen der Erweiterungen einzuführen. In diesem Fall sind die Körper 13, 14 im wesentlichen parallel zu den oberen und unteren Kühlflächen im Ausführungsbeispiel der Fig. 3 angeordnet. Zweckmäßigerweise läßt sich diese Ausführung insbesondere mit dem Verschließen der durchbohrten Trennwände aus dem Beispiel der Figur 3 verbinden.

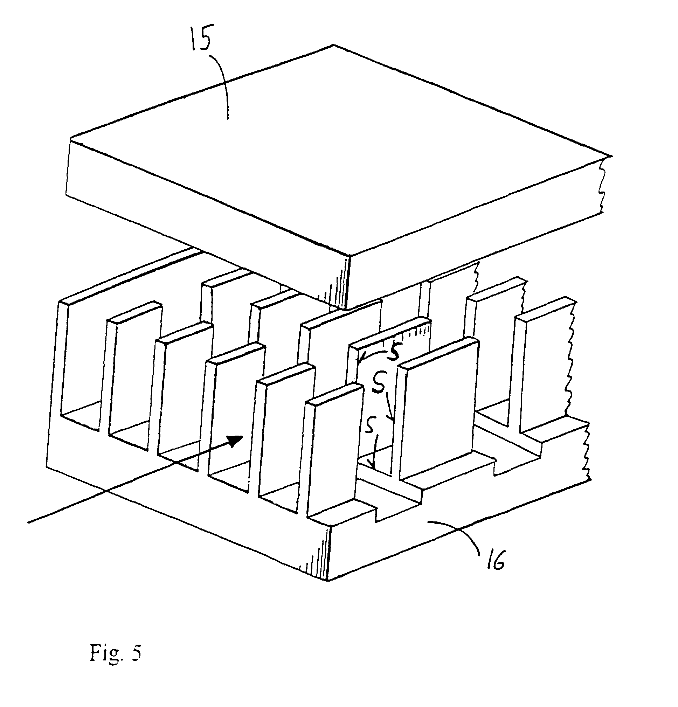

In Fig. 5 ist ein Beispiel eines erfindungsgemäßen mehrstückigen Kühlkörpers mit Strömungsabrißzentren dargestellt. Der Kühlkörper besteht aus einer oberen und einer unteren Hälfte. Beide Hälften können auf der Außenseite Bauelemente zur Kühlung aufnehmen. Die obere Hälfte 15 ist als einfache Platte ausgebildet. Die untere Hälfte 16 ist auf der der oberen Hälfte 15 zugewandten Innenseite mit einer Reihe von parallelen Kanälen durchzogen, die vorzugsweise gefräst sind. Diese Kanäle bilden die Kühlkanäle. Die Strömungsrichtung ist mit einem Pfeil angedeutet. Quer zu den Kanälen ist durchgehend Material aus den Trennwänden und den Kanälen ausgebrochen; die Stoßkanten zwischen den Ausbrüchen und den Kanälen bilden die Strömungsabrißzentren in den Kühlkanälen. Mit der oberen Hälfte 15 wird die untere Hälfte 16 verschlossen. In der Figur ist daher die Stoßkanten nur an drei von vier möglichen Kühlkanalwänden ausgebildet. Stellvertretend für die Verhältnisse in den Kühlkanälen sind an einem der Kühlkanäle die Strömungsabrißzentren S hervorgehoben. Es ist auch möglich, die beiden Hälften in etwa symmetrisch auszubilden und geeignet zu verschließen.

Eine Ausführungsform mit einer oberen und unteren Hälfte, insbesondere mit einer einfachen, unstrukturierten Hälfte 15, ermöglicht es auf einfache und für die Kühlung sehr günstige Weise, Körper als zusätzliche Strömungsabrißzentren in einen oder mehrere Kühlkanäle einzubringen. Die Körper sind mit der dem Kühlmedium zugewandten Innenseite der Hälfte 15 so verbunden, daß sie wie Finger quer zur Strömungsrichtung in den oder die Kühlkanäle hineinragen. Die Finger können auf geeignete Weise mit der Hälfte 15 verbunden sein, bevorzugt sind die Finger materialschlüssig mit der Hälfte verbunden. Die Finger können rund oder scharfkantig ausgebildet sein. Vorzugsweise ragen die Finger dort in den oder die Kühlkanäle hinein, wo erfindungsgemäß Erweiterungen angeordnet sind. Es ist jedoch auch möglich, zusätzliche Strömungsabrißzentren durch stabförmige Körper quer zur Strömungsrichtung und parallel zu den Ausbrüchen anzuordnen. Diese können ähnlich wie im Ausführungsbeispiel der Fig. 3 auch zur Abdichtung der Kühlkanäle untereinander eingesetzt werden.

Ein Vorteil ist die relativ einfache Fertigung der Anordnung. Ein weiterer Vorteil besteht darin, daß die innere Oberfläche des Kühlkörpers insgesamt zusätzlich vergrößert ist und im Bereich der Erweiterung die Kühlung verbessert ist.

Die erfindungsgemäßen Kühlkörper sind aus einem gut wärmeleitenden Material gebildet. Bevorzugt wird Aluminium oder eine Aluminiumlegierung verwendet. Werden höhere Ansprüche an die elektrische Isolierfähigkeit gestellt, eignet sich ein keramischer Werkstoff, insbesondere Aluminiumnitrid. Für ein derartiges Material ist besonders die Ausführungsform eines mehrteiligen Kühlkörper geeignet, da mit dieser die Keramikverarbeitung und Keramikbearbeitung einfacher ist.

## Patentansprüche

1. Kühlkörper mit mehreren, parallel zueinander verlaufenden, beidseitig offenen Kühlkanälen zur Aufnahme eines Kühlmediums, das den Kühlkanälen mit einer vorgegebenen Geschwindigkeit zugeführt ist, mit einer oberen und einer unteren äußeren Kühloberfläche zur Aufnahme von zu kühlenden Körpern, wobei die Kühlkanäle über ihre Länge mit annähernd konstantem Querschnitt und mit Strömungsabrißzentra ausgebildet sind,
**dadurch gekennzeichnet**,
daß die Strömungsabrißzentra in Form von quer zur Strömungsrichtung verlaufenden in dem Kühlkörper, die Kühlkanäle verbindenden Bohrungen vorgesehen sind, die partiell eine Erweiterung des Kühlkanalquerschnitts quer zur Strömungsrichtung bilden und
daß die Umfangskurve des Gesamtquerschnitts des Kühlkanals (2) im Bereich der Erweiterung (4, 4', 12') quer zur Strömungsrichtung in ihren beiden Dimensionen größere Abmessungen als die Umfangskurve des Querschnitts des Kühlkanals (2) außerhalb der Erweiterung (4, 4', 12') aufweist.

2. Kühlkörper nach Anspruch 1,
dadurch gekennzeichnet,
daß der Gesamtquerschnitt des Kühlkanals (2) mit einer Höhe und einer Tiefe quer zur Strömungsrichtung um mindestens das Doppelte der lokalen Strömungsgrenzschichtdicke bei ungestörter Strömung erweitert ist.

3. Kühlkörper nach Anspruch 1,
dadurch gekennzeichnet,
daß die Stoßkanten (S) am Übergang zwischen den Erweiterungen (4, 4', 12') und dem Kühlkanal (2) scharfkantig ausgebildet sind.

4. Kühlkörper nach einem der vorangegangenen Ansprüche,
dadurch gekennzeichnet,
daß die Erweiterungen (4, 4', 12') umlaufend um den Kanalquerschnitt ausgebildet sind.

5. Kühlkörper nach einem der vorangegangenen Ansprüche,
dadurch gekennzeichnet,
daß die zweite und die jeweils aufeinander folgenden Erweiterungen (4, 4', 12') in Strömungsrichtung derartige Abstände zueinander aufweisen, daß der Wärmeübergangskoeffizient α auf höchstens ein Viertel seines jeweiligen Anfangswertes hinter der vorangegangenen Erweiterungen (4, 4', 12') gefallen ist.

6. Kühlkörper nach einem der vorangegangenen Ansprüche,
dadurch gekennzeichnet,
daß der Kühlkanal (2) quer zur Strömungsrichtung Bohrungen (12) aufweist, deren Querschnitt parallel zur Strömungsrichtung größer als die Abmessungen des Kühlkanals quer zur Strömungsrichtung ist.

7. Kühlkörper nach einem der vorangegangenen Ansprüche,
dadurch gekennzeichnet,
daß die Trennwände und/oder Begrenzungswände des Kühlkanales (2) mindestens einseitig materialschlüssig mit den Kühlkörperoberflächen (10, 10') verbunden sind.

8. Kühlkörper nach einem der vorangegangenen Ansprüche,
dadurch gekennzeichnet,
daß der Kühlkörper (1, 9) aus einem Stück gebildet ist.

9. Kühlkörper nach einem der vorangegangenen Ansprüche 1-7,
dadurch gekennzeichnet,
daß der Kühlkörper (1, 9) aus einem oberen und einem unteren Stück (15,16) zumindest mittelbar zusammengesetzt ist.

10. Kühlkörper nach Anspruch 9,
dadurch gekennzeichnet,
daß das obere und das untere Stück (15, 16) Aushebungen in Strömungsrichtung aufweisen.

11. Kühlkörper nach Anspruch 9 oder 10,
dadurch gekennzeichnet,
daß das obere und/oder das untere Stück (15, 16) Aushebungen quer zur Strömungsrichtung aufweist.

12. Kühlkörper nach Anspruch 9,
dadurch gekennzeichnet,
daß das obere oder das untere Stück (15, 16) Aushebungen in Strömungsrichtung aufweist.

13. Kühlkörper nach Anspruch 12,
dadurch gekennzeichnet,
daß das obere oder das untere Stück (15, 16) mit Aushebungen in Strömungsrichtung in regelmäßigen Abständen Aushebungen quer zur Strömungsrichtung aufweist.

14. Kühlkörper nach einem der vorangegangenen Ansprüche,
dadurch gekennzeichnet,
daß der Kühlkörper (1, 9) Strömungsabrißzentren (13, 14) im Kühlkanal (2) aufweist, die parallel zur oberen und unteren Kühloberfläche angeordnet sind.

15. Kühlkörper nach Anspruch 14,
dadurch gekennzeichnet,
daß der Kühlkörper (1, 9) Strömungsabrißzentren (13, 14) im Kühlkanal (2) aufweist, die senkrecht zur oberen und unteren Kühloberfläche angeordnet sind.

16. Kühlkörper nach Anspruch 14 oder 15,
dadurch gekennzeichnet,
daß die Strömungsabrißzentren (13, 14) im Bereich der Erweiterung (4, 4', 12') des Kühlkanals (2) angeordnet sind.

17. Kühlkörper nach Anspruch 16,
dadurch gekennzeichnet,
daß der Querschnitt der Strömungsabrißzentren (13, 14) quer zur Strömungsrichtung kleiner ist als der Flächenzuwachs des Kühlkanalquerschnitts im Bereich der Erweiterungen.

18. Kühlkörper nach einem der vorangegangenen Ansprüche,
dadurch gekennzeichnet,
daß der Kühlkörper (1, 9) aus einem metallischen Werkstoff gebildet ist.

19. Kühlkörper nach einem der vorangegangenen Ansprüche,
dadurch gekennzeichnet,
daß der Kühlkörper (1, 9) aus Aluminium oder einer Aluminiumlegierung gebildet ist.

## Claims

1. Cooling body with a plurality of parallel, double-ended cooling ducts for the passage of a cooling medium fed into the cooling ducts at a preset velocity, with an upper and a lower external cooling surface on which bodies to be cooled can be mounted, the cooling ducts being designed to have an approximately constant cross-section along their length and provided with flow separation centres,
**characterized in that**
the flow separation centres provided have the form of bores extending at right angles to the direction of flow in the cooling body and connecting the cooling ducts, said bores resulting in a partial widening of the cooling duct cross-section at right angles to the direction of flow, and in that the peripheral curve of the total cross-section of the cooling duct (2) in the area of the widening (4, 4', 12') at right angles to the direction of flow is larger in both dimensions than the peripheral curve of the cross-section of the cooling duct (2) outside the widening (4, 4', 12').

2. Cooling body according to claim 1,
characterized in that
the total cross-section of the cooling duct (2) is, in height and width at right angles to the direction of flow, increased by at least twice the local boundary layer thickness prevailing in undisturbed flow conditions.

3. Cooling body according to claim 1,
characterized in that
the borderings (S) at the transition between the widenings (4, 4', 12') and the cooling duct (2) are sharp-edged.

4. Cooling body according to any of the preceding claims,
characterized in that
the widenings (4, 4', 12') are designed to be continuous around the duct cross-section.

5. Cooling body according to any of the preceding claims,
characterized in that
the second and any subsequent widenings (4, 4', 12') in the direction of flow are arranged at intervals which ensure that the coefficient of heat transfer α has not dropped below a quarter of its initial value downstream of the preceding widening (4, 4', 12').

6. Cooling body according to any of the preceding claims,
characterized in that
the cooling duct (2) is provided with bores (12) at right angles to the direction of flow, the cross-section of which bores parallel to the direction of flow exceeds the dimensions of the cooling duct at right angles to the direction of flow.

7. Cooling body according to any of the preceding claims,
characterized in that
the partitions and/or boundary walls of the cooling duct (2) are materially linked to the cooling body surfaces (10, 10') on at least one side.

8. Cooling body according to any of the preceding claims,
characterized in that
the cooling body (1, 9) is made of a single part.

9. Cooling body according to any of the preceding claims 1-7,
characterized in that
the cooling body (1, 9) is at least indirectly assembled from an upper and a lower part (15, 16).

10. Cooling body according to claim 9
characterized in that
the upper and lower parts (15, 16) are provided with recesses in the direction of flow.

11. Cooling body according to claim 9 or 10,
characterized in that
the upper and/or lower parts (15, 16) are provided with recesses at right angles to the direction of flow.

12. Cooling body according to claim 9,
characterized in that
the upper or lower part (15, 16) is provided with recesses in the direction of flow.

13. Cooling body according to claim 12,
characterized in that
the upper or lower part (15, 16) with recesses in the direction of flow is provided with recesses at right angles to the direction of flow at regular intervals.

14. Cooling body according to any of the preceding claims,
characterized in that
the cooling body (1, 9) is provided with flow separation centres (13, 14) in the cooling duct (2), which are arranged parallel to the upper and lower cooling surfaces.

15. Cooling body according to claim 14,
characterized in that
the cooling body (1, 9) is provided with flow separation centres (13, 14) in the cooling duct (2), which are arranged at right angles to the upper and lower cooling surfaces.

16. Cooling body according to claim 14 or 15.
characterized in that
the flow separation centres (13, 14) are located in the area of the widenings (4, 4', 12') of the cooling duct (2).

17. Cooling body according to claim 16,
characterized in that
the cross-section of the flow separation centres (13, 14) at right angles to the direction of flow is less than the increase in area of the cooling duct cross-section in the area of the widenings.

18. Cooling body according to any of the preceding claims,
characterized in that
the cooling body (1, 9) is made of a metallic material.

19. Cooling body according to any of the preceding claims,
characterized in that
the cooling body (1, 9) is made of aluminium or an aluminium alloy.

## Revendications

1. Refroidisseur comportant plusieurs canaux de refroidissement, ouverts sur les deux côtés, courant parallèlement les uns aux autres, et destinés à recevoir un fluide de refroidissement, qui est aménagé aux canaux de refroidissement à une vitesse prédéfinie, et comportant une surface de refroidissement extérieure supérieure et une surface de refroidissement extérieure inférieure destinée à recevoir des objets à refroidir, les canaux de refroidissement étant, sur toute leur longueur, configurés avec une section presque constante et avec des centres de décollement de l'écoulement, caractérisé en ce que les centres de décollement sont prévus sous forme de trous, qui courent dans le refroidisseur perpendiculairement à la direction de l'écoulement et qui relient les canaux de refroidissement, trous qui forment partiellement un élargissement de la section transversale du canal de refroidissement perpendiculairement à la direction de l'écoulement, et en ce que la circonférence de la section transversale totale du canal de refroidissement (2) présente, dans la zone de l'élargissement (4, 4', 12'), perpendiculairement à la direction de l'écoulement, et dans ses deux dimensions, des dimensions plus grandes que la circonférence de la section transversale du canal de refroidissement (2) à l'extérieur de l'élargissement (4,4',12').

2. Refroidisseur selon la revendication 1, caractérisé en ce que la section transversale totale du canal de refroidissement (2) est élargie avec, transversalement à la direction de l'écoulement, une hauteur et une profondeur au moins doubles de l'épaisseur de la couche limite locale en présence d'un écoulement non-perturbé.

3. Refroidisseur selon la revendication 1, caractérisé en ce que les bords (S), au niveau de la transition entre les élargissements (4, 4', 12') et le canal de refroidissement (2), sont réalisés à arêtes vives.

4. Refroidisseur selon l'une des revendications précédentes, caractérisé en ce que les élargissements (4, 4', 12') sont configurés de façon à entourer la section transversale du canal.

5. Refroidisseur selon l'une des revendications précédentes, caractérisé en ce que le deuxième élargissement et chacun des élargissements successifs (4, 4', 12') présentent entre eux, dans la direction de l'écoulement, des distances telles que le coefficient de transmission thermique α tombe au plus au quart de sa valeur initiale en aval des élargissements précédents (4, 4', 12').

6. Refroidisseur selon l'une des revendications précédentes, caractérisé en ce que le canal de refroidissement (2) présente, perpendiculairement à la direction de l'écoulement, des trous (12) dont la section transversale, parallèlement à la direction de l'écoulement, est supérieure aux dimensions du canal de refroidissement perpendiculairement à la direction de l'écoulement.

7. Refroidisseur selon l'une des revendications précédentes, caractérisé en ce que les cloisons et/ou parois de délimitation du canal de refroidissement (2) sont au moins sur une face reliés par une liaison par le matériau aux surfaces (10,10') du refroidisseur.

8. Refroidisseur selon l'une des revendications précédentes, caractérisé en ce que le refroidisseur (1, 9) est constitué d'une pièce.

9. Refroidisseur selon l'une des revendications 1 à 7, caractérisé en ce que le refroidisseur (1, 9) est constitué, au moins d'une manière indirecte, d'une pièce supérieure et d'une pièce inférieure (15, 16).

10. Refroidisseur selon la revendication 9, caractérisé en ce que la pièce supérieure et la pièce inférieure (15, 16) présentent des zones d'enlèvement dans la direction de l'écoulement.

11. Refroidisseur selon la revendication 9 ou 10, caractérisé en ce que la pièce supérieure et/ou la pièce inférieure (15, 16) comporte des zones d'enlèvement transversalement à la direction de l'écoulement

12. Refroidisseur selon la revendication 9, caractérisé en ce que la pièce supérieure ou la pièce inférieure (15, 16) comporte des zones d'enlèvement dans la direction de l'écoulement.

13. Refroidisseur selon la revendication 12, caractérisé en ce que la pièce supérieure ou la pièce inférieure (15, 16), qui comporte des zones d'enlèvement dans la direction de l'écoulement, présente en des points équidistants des zones d'enlèvement transversalement à la direction de l'écoulement.

14. Refroidisseur selon l'une des revendications précédentes, caractérisé en ce que le refroidisseur (1, 9) comporte dans le canal de refroidissement (2) des centres de décollement de l'écoulement (13, 14), qui sont disposés parallèlement à la surface de refroidissement supérieure et à la surface de refroidissement inférieure.

15. Refroidisseur selon la revendication 14, caractérisé en ce que le refroidisseur (1, 9) comporte dans le canal de refroidissement (2) des centres de décollement de l'écoulement (13, 14), qui sont disposés perpendiculairement à la surface de refroidissement supérieure et à la surface de refroidissement inférieure.

16. Refroidisseur selon la revendication 14 ou 15, caractérisé en ce que les centres de décollement de l'écoulement (13, 14) sont disposés dans la zone de l'élargissement (4, 4', 12') du canal de refroidissement (2).

17. Refroidisseur selon la revendication 16, caractérisé en ce que la section transversale des centres de décollement de l'écoulement (13, 14) transversalement à la direction de l'écoulement est plus petite que l'augmentation d'aire de la section transversale du canal de refroidissement dans la zone des élargissements.

18. Refroidisseur selon l'une des revendications précédentes, caractérisé en ce que le refroidisseur (1, 9) est constitué d'un matériau métallique.

19. Refroidisseur selon l'une des revendications précédentes, caractérisé en ce que le refroidisseur (1, 9) est constitué d'aluminium ou d'un alliage d'aluminium.
